# EUROPEAN PATENT APPLICATION

(11) **EP 2 405 720 A1**
(43) Date of publication of application: **11.01.2012**
(21) Application number: 10748856.1
(22) Date of filing: 01.03.2010
(51) Int. Cl.: H05B 33/10, H01L 51/50, H05B 33/12, H05B 33/22

(54) **PRODUCTION METHOD FOR AN ORGANIC ELECTROLUMINESCENCE DEVICE**

(30) Priority: 04.03.2009 JP 2009050285
(71) Applicant: Sumitomo Chemical Company, Limited, Tokyo 104-8260 (JP)
(72) Inventor: ROKUHARA, Kouichi, Shimotsuma-shi Ibaraki 304-0823 (JP)
(74) Representative: Jackson, Martin Peter
(86) International application number: PCT/JP2010/053704
(87) International publication number: WO 2010/101263

(57) **Abstract**

A method for manufacturing an organic electroluminescent device that comprises a substrate, a plurality of organic electroluminescent elements provided on the substrate, and a partition sectioning the plurality of organic electroluminescent elements, in which the plurality of organic electroluminescent elements comprise a light-emitting layer formed by a coating method and a pair of electrodes, and include a red light-emitting layer, a green light-emitting layer or a blue light-emitting layer emitting blue light as the light-emitting layer, the method comprising a step of preparing the partition having lyophilic properties and the substrate provided with one electrode of the pair of electrodes, ink supplying steps of supplying various inks, a step of solidifying the supplied inks, and a step of forming the other electrode of the pair of electrodes, wherein a red ink supplying step is performed at the last among the ink supplying steps.

## Description

### Technical Field

The present invention relates to a method manufacturing for an organic electroluminescent device comprising a plurality of organic electroluminescent elements, the organic electroluminescent device, and a display device.

### Background Art

Currently, research and development is conducted on display devices comprising a plurality of organic electroluminescent elements (hereinafter, "electroluminescent" is also referred to as "EL") functioning as light sources.

An organic EL element mounted on a display device is a light-emitting element that emits light with voltage applied thereto. The organic EL element includes a pair of electrodes and a light-emitting layer interposed between the electrodes. When voltage is applied to the organic EL element, holes are injected from one of the electrodes, and electrons are injected from the other electrode. The holes and electrons are combined in the light-emitting layer to emit light.

A display device for color displaying generally includes three types of organic EL elements of an organic EL element emitting red light, an organic EL element emitting green light and an organic EL element emitting blue light for displaying intended colors. The display device includes a partition for sectioning each organic EL element on a substrate. For example, when a grid-shaped partition is provided on a substrate, each organic EL element is provided in a respective pixel sectioned in a grid pattern by the partition. Accordingly, the organic EL elements are arranged in a matrix form.

Although the light-emitting layer of the organic EL element can be formed by various methods, the formation of the light-emitting layer by a coating method has been studied due to its simple process. For example, an ink, in which a material to be the light-emitting layer is dissolved in a solvent, is applied by a predetermined coating method and is solidified, thus forming the light-emitting layer. To form the three types of the organic EL elements described above on the substrate, it is necessary to form a red light-emitting layer emitting red light, a green light-emitting layer emitting green light and a blue light-emitting layer emitting blue light respectively at their predetermined positions. To realize this by a coating method, an ink for forming the red light-emitting layer (hereinafter may be simply referred to as a red ink), an ink for forming the green light-emitting layer (hereinafter may be simply referred to as a green ink) and an ink for forming the blue light-emitting layer (hereinafter may be simply referred to as a blue ink) need to be selectively supplied to predetermined positions. Specifically, the red ink, the green ink and the blue ink need to be selectively supplied to areas where the organic EL element emitting red light, the organic EL element emitting green light and the organic EL element emitting blue light are formed, respectively.

For example, three types of inks of the red ink, the green ink and the blue ink can be selectively supplied to predetermined areas by a predetermined coating method such as an ink-jet printing method and a relief printing method. However, when a partition has lyophilic properties, the ink supplied in the predetermined area sectioned by the partition may wet and spread along the surface of the partition to the neighboring pixel area that is separated by the partition. In this case, the so-called color mixing occurs. In other words, a light-emitting layer is formed in which the red ink, the green ink and the blue ink are mixed. Thus, when manufacturing the organic EL elements on a substrate that includes the partition having lyophilic properties, it is difficult to form a light-emitting layer emitting an intended color as designed.

To solve such a color mixing problem, a method in which an organic EL element is manufactured by using a partition having lyophobic properties formed by subjecting a partition having lyophilic properties to hydrophobizing treatment has been disclosed (see JP 2006-286241 A, for example). When the partition has lyophobic properties, a supplied ink can be prevented from wetting and spreading along the partition, and therefore, the ink supplied in a predetermined area can be prevented from spreading to the neighboring pixel area that is separated by the partition. In such a manner, the supplied ink can be reliably kept in the predetermined area. Accordingly, different types of inks can be prevented from mixing, and as a result, a light-emitting layer emitting light in an intended color can be formed as designed.

### Disclosure of the Invention

In the conventional art described above, the color mixing problem can be solved by using a partition having lyophobic properties. However, a process for changing the properties of the partition surface from lyophilic to lyophobic properties is required, which results in disadvantageous increase of the number of processes for the change.

It is an object of the present invention to provide a method for manufacturing an organic EL device, which the color mixing problem dose not become evident while using a partition having lyophilic properties and an intended organic EL element can be manufactured with fewer processes.

The present invention relates to a method for manufacturing an organic electroluminescent device that comprises a substrate, a plurality of organic electroluminescent elements provided on the substrate, and a partition sectioning the plurality of organic electroluminescent elements, in which the plurality of organic electroluminescent elements comprise a light-emitting layer formed by a coating method and a pair of electrodes arranged with the light-emitting layer interposed therebetween, and include a red light-emitting layer emitting red light, a green light-emitting layer emitting green light or a blue light-emitting layer emitting blue light as the light-emitting layer, the method comprising:
a step of preparing the substrate provided with the partition having lyophilic properties and with one electrode of the pair of electrodes;
a red ink supplying step of supplying an ink for forming the red light-emitting layer onto the one electrode for forming the red light-emitting layer by the coating method;
a green ink supplying step of supplying an ink for forming the green light-emitting layer onto the one electrode for forming the green light-emitting layer by the coating method;
a blue ink supplying step of supplying an ink for forming the blue light-emitting layer onto the one electrode for forming the blue light-emitting layer by the coating method;
a step of solidifying the supplied inks; and
a step of forming the other electrode of the pair of electrodes, wherein
the red ink supplying step is performed at the last among the red ink supplying step, the blue ink supplying step and the green ink supplying step.

An example of embodiments of this invention includes a method for manufacturing an organic electroluminescent device that comprises a substrate, a plurality of organic electroluminescent elements provided on the substrate, and a partition sectioning the plurality of organic electroluminescent elements, in which the plurality of organic electroluminescent elements comprise:
an organic electroluminescent element (A) comprising a red light-emitting layer emitting red light formed by the coating method and a pair of electrodes arranged with the red light-emitting layer interposed therebetween;
an organic electroluminescent element (B) comprising a green light-emitting layer emitting green light formed by the coating method and a pair of electrodes arranged with the green light-emitting layer interposed therebetween; and
an organic electroluminescent element (C) comprising a blue light-emitting layer emitting blue light formed by the coating method and a pair of electrodes arranged with the blue light-emitting layer interposed therebetween, the method comprising:
a step of preparing the substrate provided with the partition having lyophilic properties and with one electrode of the pair of electrodes that constitute each of the plurality of organic electroluminescent elements;
a red ink supplying step of supplying an ink for forming the red light-emitting layer onto the one electrode of the organic electroluminescent element (A) by the coating method;
a green ink supplying step of supplying an ink for forming the green light-emitting layer onto the one electrode of the organic electroluminescent element (B) by the coating method;
a blue ink supplying step of supplying an ink for forming the blue light-emitting layer onto the one electrode of the organic electroluminescent element (C) by the coating method;
a step of solidifying the supplied inks; and
a step of forming the other electrode of the pair of electrodes, wherein
the red ink supplying step is performed at the last among the red ink supplying step, the blue ink supplying step and the green ink supplying step.

The present invention also relates to the said method for manufacturing an organic electroluminescent device, wherein the green ink supplying step is performed after the blue ink supplying step.

The present invention also relates to the said method for manufacturing an organic electroluminescent device, wherein the coating method is a nozzle coating method or a plate printing method.

The present invention also relates to the said method for manufacturing an organic electroluminescent device, wherein the coating method is a relief printing method.

The present invention also relates to the said method for manufacturing an organic electroluminescent device, wherein
the inks contain a solvent having a boiling point of 200°C or higher, and
a proportion of the solvent having a boiling point of 200°C or higher to the ink is 5% by weight or larger.

The present invention also relates to an organic electroluminescent device comprising a substrate, a plurality of organic electroluminescent elements provided on the substrate, and a partition sectioning the plurality of organic electroluminescent elements, wherein
the plurality of organic electroluminescent elements comprise a light-emitting layer formed by a coating method and a pair of electrodes arranged with the light-emitting layer interposed therebetween, and include a red light-emitting layer emitting red light, a green light-emitting layer emitting green light or a blue light-emitting layer emitting blue light as the light-emitting layer,
the partition has lyophilic properties, and
one end of the green light-emitting layer and/or the blue light-emitting layer extends along the partition onto the neighboring red light-emitting layer separated by the partition.

The present invention also relates to a display device comprising the said organic electroluminescent device.

### Brief Description of the Drawings

FIG. 1 is a schematic plan view of an organic electroluminescent (EL) device 1 in accordance with an embodiment of the present invention.
FIG. 2 is an enlarged schematic sectional view of one pixel area of the organic EL device 1 illustrated in FIG. 1.
FIG. 3 illustrates the behavior of inks when the inks are applied and the formation of a light-emitting layer 5.

### Explanations of Letters or Numerals

- 1: organic EL device
- 2: substrate
- 3: organic EL element
- 4: partition
- 5: light-emitting layer
- 6: one electrode (anode)
- 7: the other electrode (cathode)
- 8: insulating film
- 9: hole injection layer
- 11: concave portion

### Embodiments for Carrying Out the Invention

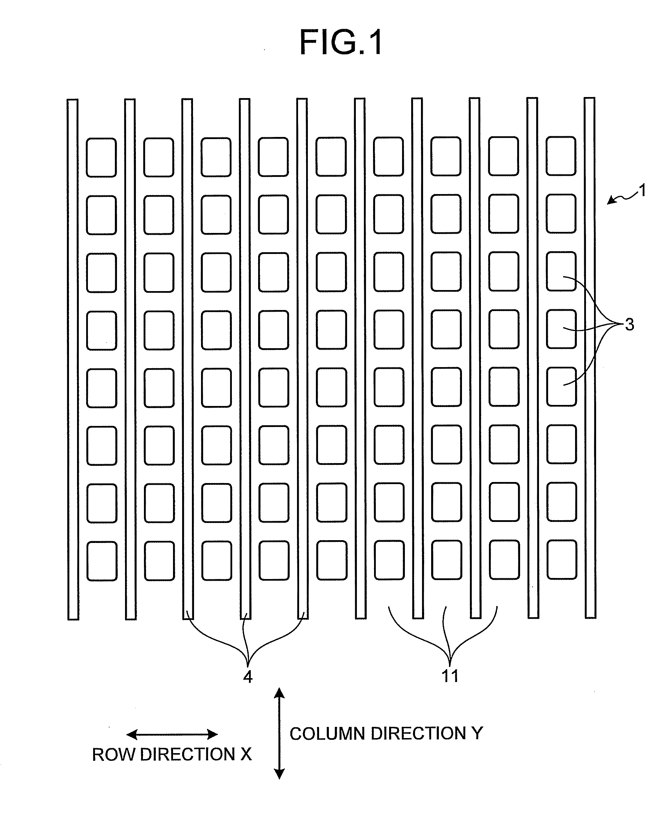

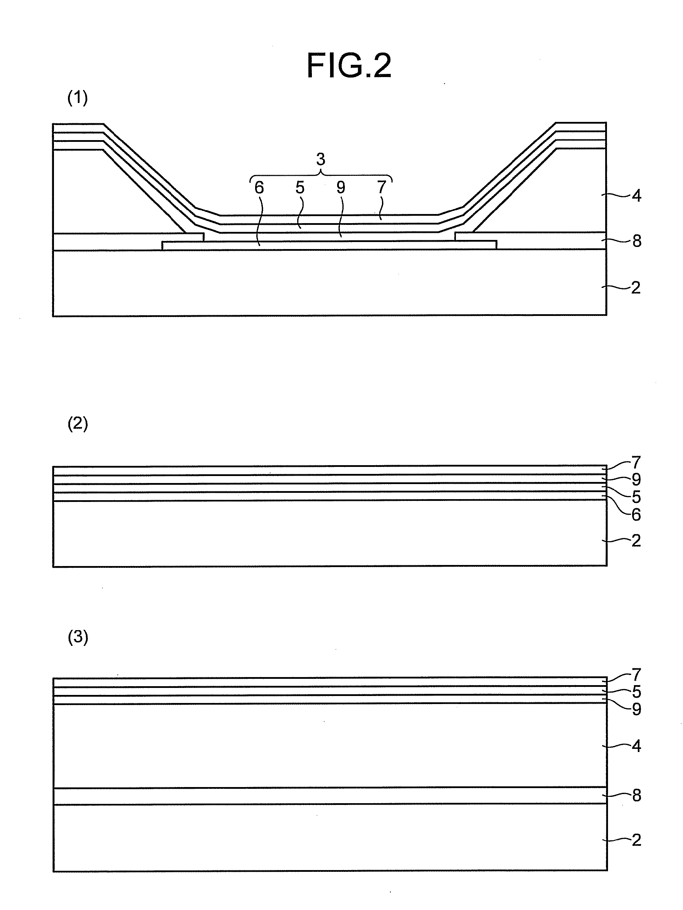

FIG. 1 is a schematic plan view of an organic electroluminescent (EL) device 1 in accordance with an embodiment of the present invention, and FIG. 2 is an enlarged schematic sectional view of one pixel area of the organic EL device 1 illustrated in FIG. 1. In the present specification, one pixel is constituted with one organic EL element. FIG. 2(1) is a schematic sectional view of the organic EL device 1 taken along a cut surface vertical to a column direction Y in FIG. 1, and FIGs. 2(2) and (3) are schematic sectional views of the organic EL device 1 taken along a cut surface vertical to a row direction X in FIG. 1. FIGs. 2(1) and (2) are schematic sectional views of the organic EL device 1 taken along cut surfaces passing through one electrode 6, and FIG. 2(3) is a schematic sectional view of the organic EL device 1 taken along a cut surface passing through a partition 4.

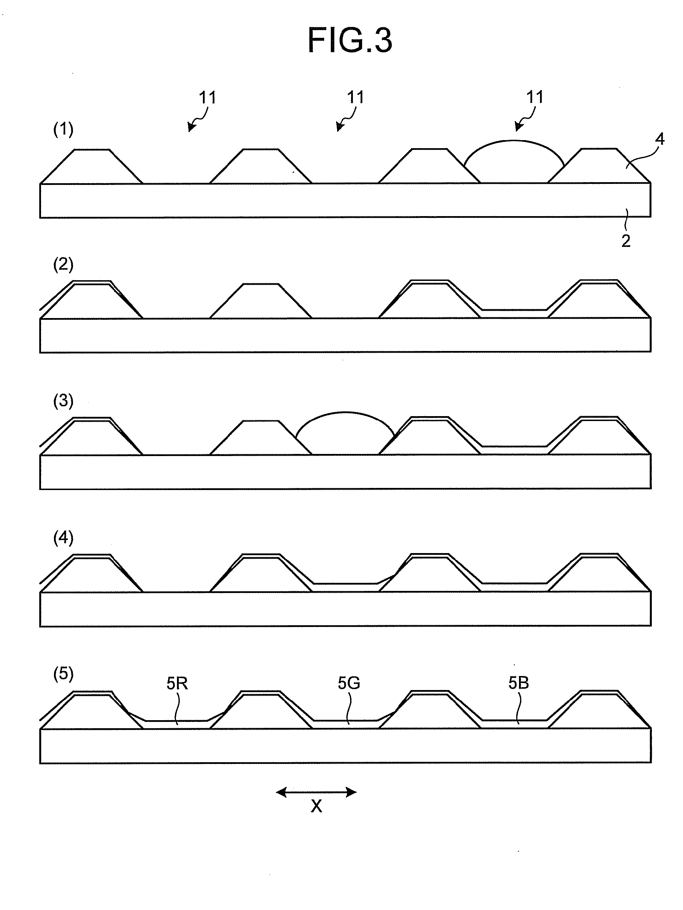

The organic EL device 1 of the present embodiment comprises a substrate 2, a plurality of organic EL elements 3 provided on the substrate 2, and the partition 4 sectioning the organic EL elements. The organic EL element 3 includes a light-emitting layer 5 formed by a coating method, and a pair of electrodes 6 and 7 that are arranged with the light-emitting layer 5 interposed therebetween. The organic EL element 3 includes a red light-emitting layer 5R emitting red light, a green light-emitting layer 5G emitting green light or a blue light-emitting layer 5B emitting blue light as the light-emitting layer 5 (see FIG. 3(5) to be described later).

A method for manufacturing the organic EL device of the present embodiment comprises a step of preparing the substrate 2 provided with the partition 4 having lyophilic properties and with the one electrode 6 of the pair of electrodes 6 and 7; a red ink supplying step of supplying an ink for forming the red light-emitting layer 5R onto the one electrode 6 by a coating method; a green ink supplying step of supplying an ink for forming the green light-emitting layer 5G onto the one electrode 6 by the coating method; a blue ink supplying step of supplying an ink for forming the blue light-emitting layer 5B onto the one electrode by the coating method; a step of solidifying the supplied inks; and a step of forming the other electrode 7 of the pair of electrodes, wherein the red ink supplying step is performed at the last among the red ink supplying step, the blue ink supplying step and the green ink supplying step.

### 1) Structure of organic EL device

The structure of the organic EL device 1 is described below. Although the organic EL device 1 is described below with an example of the organic EL device 1 in an active matrix driving system, the present invention is not limited to the active matrix driving system and, for example, is also applicable to a passive matrix driving system.

In the present embodiment, the plurality of organic EL elements 3 are provided on the substrate 2 in a matrix form. In other words, the plurality of organic EL elements 3 are discretely arranged on the substrate 2 to be spaced at regular intervals in the row direction X as well as to be spaced at regular intervals in the column direction Y.

The plurality of partitions 4 extending in the column direction Y are provided on the substrate 2. The partitions 4 are each arranged between the organic EL elements 3 neighboring in the row direction X and are arrayed to be spaced from each other at regular intervals in the row direction X. In other words, the organic EL elements 3 are arranged between the partitions 4 neighboring in the row direction X, and, in an area between the partitions 4 neighboring in the row direction X, the plurality of organic EL elements 3 are arranged to be spaced from each other at regular intervals in the column direction Y. In the present embodiment, the partitions 4 are arranged in a stripe pattern as illustrated in FIG. 1. However, in another embodiment, the partitions 4 may be arranged in a grid pattern.

In the present embodiment, three types of organic EL elements of an organic EL element emitting red light, an organic EL element emitting green light and an organic EL element emitting blue light are provided on the substrate 2. In the present embodiment, the organic EL elements of the same type are provided in one column. For example, on the substrate 2, (I) a column in which the organic EL elements emitting red light are provided, (II) a column in which the organic EL elements emitting green light are provided, and (III) a column in which the organic EL elements emitting blue light are provided are each arranged at intervals of two columns. Besides these three types of organic EL elements, for example, an organic EL element emitting white light may be provided in order to reduce electric power consumption.

On one surface of the substrate 2 in the thickness direction, one electrode 6 of the pair of electrodes is provided. In the present embodiment, an anode is provided as the one electrode and a cathode is provided as the other electrode. Therefore, the one electrode is referred to as the anode 6 and the other electrode is referred to as the cathode 7, hereinafter. In the present specification, one thickness direction of the substrate 2 may be referred to as "above" or "onto" and the other thickness direction may be referred to as "below" or "under", hereinafter.

The anode 6 is provided on the substrate 2 in a matrix form. One anode 6 is provided to one organic EL element 3. In other words, the same number of anodes 6 as the organic EL elements 3 are provided. The anodes 6 are discretely arranged on the substrate 2 to be spaced at regular intervals in the row direction X as well as to be spaced at regular intervals in the column direction Y. The anode 6 is flat and is formed in a substantially rectangular shape as viewed from one side of the substrate 2 in the thickness direction (hereinafter may be referred to as "in a plan view"). The anodes 6 are provided between the partitions 4 neighboring in the row direction X in a plan view and are arranged to be spaced at regular intervals in the column direction Y between the partitions 4. In the present embodiment, both ends of the anode 6 overlap the partitions 4 in the row direction X in a plan view. Both ends of the anode 6 need not overlap the partitions 4 in the row direction X in a plan view.

In the present embodiment, an insulating film 8 is further provided on the substrate 2. The insulating film 8 has electric insulating properties and is provided in order to electrically insulate each organic EL element 3. The insulating film 8 is mainly formed in an area except for the anodes 6 and is provided in a grid pattern so that a portion of the insulating film 8 covers the periphery of the anode 6. In other words, the insulating film 8 is provided from above so as to cover the whole surface of the substrate 2 with the anodes 6 formed thereon, and openings from which the anodes 6 are exposed are formed in a matrix form. Each of the anodes 6 is electrically insulated because such an insulating film 8 is interposed between the anodes 6, and therefore, each organic EL element 3 is also electrically insulated. The insulating film 8 need not be provided depending on the design, for example, when the partition 4 having function to electrically insulate each organic EL element 3 is provided.

A portion of the organic EL element where the opening is formed in a plan view mainly emits light. The size of the opening is designed according to resolution and required properties, and the width of the opening is generally about 20 µm to 500 µm in the row direction X and the column direction Y.

As described above, the partitions 4 extend in the column direction Y and are arranged to be spaced from each other at predetermined intervals in the row direction X. In the present embodiment, the partition 4 is provided on the insulating film 8 between the neighboring openings. The partition 4 has lyophilic properties to an ink to be described later. In the present specification, a partition has lyophilic properties, which means that a contact angle of an ink for forming a light-emitting layer with the partition is 30° or smaller. The interval of the partitions 4 in the row direction X is designed according to resolution and required properties and is generally about 20 µm to 500 µm.

In the organic EL element 3, besides the light-emitting layer 5, a predetermined layer may further be provided between the pair of electrodes 6 and 7 in consideration of element characteristics, simplicity of processes, and the like. In the present embodiment, a hole injection layer 9 is further provided as such a predetermined layer. The hole injection layer 9 is provided between the anode 6 and the light-emitting layer 5. In the present embodiment, the hole injection layer 9 is formed by a coating method as with the light-emitting layer 5. As described later, when an ink for forming the hole injection layer 9 is applied by a spin coating method, the ink wets and spreads on the partition 4 because of the lyophilic properties of the partition 4, and as a result, the hole injection layer 9 is formed over the whole surface of the substrate. Even when the ink is supplied to the portion between the partitions 4 neighboring in the column direction Y using a coating method capable of pattern coating, the supplied ink wets and spreads along the surface of the partitions 4 because of the lyophilic properties of the partitions 4, and as a result, the hole injection layer 9 is formed not only on the anode 6 but also on the partition 4. Accordingly, when the partition 4 having lyophilic properties is used, the hole injection layer 9 is formed along and all over the exposed surfaces of the anode 6, the insulating film 8 and the partition 4.

The light-emitting layer 5 is formed by a coating method. In the present embodiment, the light-emitting layer 5 is formed on the hole injection layer 9. An ink for forming the light-emitting layer 5 wets and spreads on the hole injection layer 9, and therefore, the light-emitting layer 5 is formed on the partition 4 as well as on the hole injection layer 9 in a plan view. In the present embodiment, three types of organic EL elements of the organic EL element emitting red light, the organic EL element emitting green light and the organic EL element emitting blue light are provided. The red light-emitting layer 5R emitting red light is provided in the organic EL element emitting red light, the green light-emitting layer 5G emitting green light is provided in the organic EL element emitting green light, and the blue light-emitting layer 5B emitting blue light is provided in the organic EL element emitting blue light. In the present specification, red light-emission, green light-emission, and blue light-emission mean light having a peak wavelength of 600 nm or more and less than 750 nm, light having a peak wavelength of 500 nm or more and less than 600 nm, and light having a peak wavelength of 400 nm or more and less than 500 nm, respectively.

The cathode (the other electrode of the pair of electrodes) 7 is formed onto the light-emitting layer 5 so that the cathode 7 is formed all over the substrate across the organic EL elements 3. In other words, the cathode 7 is formed across every organic EL elements 3, and is provided as a common electrode for every organic EL elements.

### 2) Method for manufacturing organic EL device

### (Step of preparing substrate)

The substrate 2 provided with the partition 4 having lyophilic properties and the anode 6 (the one electrode of the pair of electrodes) is prepared. The substrate 2 may be obtained as a substrate with the partition 4 and the anode 6 previously formed thereon, or may be prepared by forming the partition 4 and the anode 6 on the substrate 2.

### <Substrate>

A substrate that is not chemically deformed during a process of manufacturing the organic EL device is suitably used. For example, glass, plastic, polymer films, silicon plates, and stacked bodies thereof are used. For an active matrix driving display device, a substrate on which a circuit for driving an organic EL element is previously formed is preferably used. For example, a substrate on which a thin film transistor (TFT) is previously formed may be used. For a device having a structure in which light emitted from the light-emitting layer is extracted through the one electrode and the substrate, a substrate having high visible light transparency is preferable.

### <Anode>

In an organic EL element having a structure in which light emitted from the light-emitting layer is extracted through the anode, an electrode having light transparency is used for the anode. For the electrode having light transparency, a thin film of metal oxides, metal sulfides, metals, or the like may be used, and an electrode with high electric conductivity and high light transparency is suitably used. Specifically, a thin film of, for example, indium oxide, zinc oxide, tin oxide, indium tin oxide (Abbrev.: ITO), indium zinc oxide (Abbrev.: IZO), gold, platinum, silver, copper, and the like is used. Among them, a thin film of ITO, IZO or tin oxide is suitably used. Examples of a method for manufacturing the anode may include a vacuum deposition method, a sputtering method, an ion plating method and a plating method. For the anode, an organic transparent conductive film such as polyaniline or derivatives thereof and polythiophene or derivatives thereof may also be used.

The thickness of the anode is designed in consideration of required properties, simplicity of processes, and the like. The thickness of the anode is, for example, 10 nm to 10 µm, preferably 20 nm to 1µm, and further preferably 50 nm to 500 nm.

### <Insulating film>

The insulating film 8 generally comprises a member having lyophilic properties. For example, when the insulating film is formed of a member having lyophobic properties, the ink for forming the hole injection layer 9 dries while being repelled by the insulating film during the formation of the hole injection layer 9. As a result, the thickness of the periphery of the hole injection layer 9 becomes nonuniform on the anode 6, which makes it difficult to obtain the hole injection layer having a uniform thickness. In contrast, when the insulating film 8 is formed of a member having lyophilic properties, the ink for forming the hole injection layer 9 wets and spreads on the insulating film 8. Therefore, the insulating film 8 hardly affect the thickness of the hole injection layer 9, and the hole injection layer 9 having a uniform thickness can be obtained.

The insulating film 8 is made of organic substances or inorganic substances. Examples of the organic substances may include resins such as acrylic resins, phenol resins and polyimide resins, and examples of the inorganic substances may include SiOₓ and SiNₓ.

To form the insulating film made of organic substances, for example, a positive or negative photosensitive resin is applied all over the substrate to form a film, and predetermined portions of the film are exposed and developed. Subsequently, the film is cured. Thus, the insulating film 8 with openings formed at the predetermined portions thereof is obtained. A photoresist may be used for the photosensitive resin.

To form the insulating film made of inorganic substances, a thin film of inorganic substances is formed all over the substrate by a plasma CVD method, a sputtering method, or the like. Subsequently, openings are formed at predetermined portions of the thin film. Thus, the insulating film 8 with the openings formed at the predetermined portions thereof is obtained. The openings are formed by, for example, photolithography. The anode 6 is exposed by forming these openings. In such a manner, the insulating film 8 can be obtained in a grid pattern.

The thickness of the insulating film 8 is set to a value with which at least electric insulating properties can be ensured. The thickness of the insulating film 8 is, for example, 0.1 µm to 5 µm, and preferably 0.5 µm to 2 µm.

When using the materials described above, the insulating film 8 generally has lyophilic properties unless hydrophobizing treatment is further performed.

### <Partition>

The partition 4 can be formed in a manner similar to the insulating film 8. In view of simplicity of processes, the partition 4 and the insulating film 8 are preferably formed by photolithography using photosensitive resins.

The thickness of the partition 4 is designed to a value with which a supplied ink can almost be contained between the partitions 4. The thickness of the partition 4 is, for example, about 0.5 µm to 5 µm, and preferably 1 µm to 2 µm.

Wire and the like are further provided on the substrate 2, and generally, the wire and the like are covered by the partition 4. Therefore, the width of the partition 4 in the row direction X is designed to be wider than the width of the wire and the like. The width of the partition 4 in the row direction X is, for example, about 5 µm to 50 µm, and preferably 10 µm to 30 µm.

### <Hole injection layer>

Examples of hole injection materials constituting the hole injection layer may include oxides such as vanadium oxide, molybdenum oxide, ruthenium oxide and aluminum oxide, phenylamine compounds, starburst-type amine compounds, phthalocyanine compounds, amorphous carbon, polyaniline, and polythiophene derivatives.

Examples of a method for forming a film of the hole injection layer may include a film formation from a solution containing the hole injection material. For a solvent used for the film formation from the solution, a solvent that dissolves the hole injection material is preferable. Examples of the solvent may include: chlorine based solvents such as chloroform, methylene chloride and dichloroethane; ether based solvents such as tetrahydrofuran; aromatic hydrocarbon based solvents such as toluene and xylene; ketone based solvents such as acetone and methyl ethyl ketone; ester based solvents such as ethyl acetate, butyl acetate and ethyl cellosolve acetate; and water.

Examples of the method for the film formation from the solution may include coating methods such as a spin coating method, a casting method, a micro-gravure coating method, a gravure coating method, a bar coating method, a roll coating method, a wire bar coating method, a dip coating method, a spray coating method, a screen printing method, a flexo printing method, an offset printing method and an ink-jet printing method. When using thin films of the same members for each of the hole injection layers in three types of organic EL elements of the organic EL element emitting red light, the organic EL element emitting green light and the organic EL element emitting blue light, it is not necessary to form different types of the hole injection layers for each column. The hole injection layer may be formed all over the substrate across all of the organic EL elements. For example, the hole injection layer common to different types of organic EL elements can be formed all over the substrate by a spin coating method.

The thickness of the hole injection layer is appropriately designed in consideration of required properties, simplicity of processes, and the like. The thickness of the hole injection layer is, for example, 1 nm to 1 µm, preferably 2 nm to 500 nm, and further preferably 5 nm to 200 nm.

### <Light-emitting layer>

A process of forming the light-emitting layer 5 comprises an ink supplying step of supplying an ink for forming the light-emitting layer 5 to the portion between the partitions 4 and a step of solidifying the supplied ink.

The organic EL device 1 comprises the organic EL element 3 emitting red light, the organic EL element 3 emitting green light and the organic EL element 3 emitting green light. It is therefore necessary that the red light-emitting layer 5R, the green light-emitting layer 5G or the blue light-emitting layer 5B is selectively formed for each column. Accordingly, three steps of (i) a red ink supplying step of supplying an ink for forming the red light-emitting layer (hereinafter may be referred to as a "red ink") onto the one electrode by a coating method, (ii) a green ink supplying step of supplying an ink for forming the green light-emitting layer (hereinafter may be referred to as a "green ink") onto the one electrode by a coating method, and (iii) a blue ink supplying step of supplying an ink for forming the blue light-emitting layer (hereinafter may be referred to as a "blue ink") onto the one electrode by a coating method. The expression "onto the one electrode" includes both meanings of "in contact with the one electrode" and "above the one electrode via a predetermined member provided in contact with the one electrode"; therefore, it is not necessarily limited to the meaning of "in contact with the one electrode."

In the present embodiment, the red ink supplying step is performed at the last among the red ink supplying step, the blue ink supplying step and the green ink supplying step. Preferably, the green ink supplying step is performed after the blue ink supplying step. In other words, the inks are preferably supplied in the order of the blue ink supplying step, the green ink supplying step and the red ink supplying step.

The present inventors have found a phenomenon that, when the partition 4 having lyophilic properties is used, the behavior of color mixing of inks differs between the light-emitting layer formed at a former process and the light-emitting layer formed at a later process as described later. That is, while the ink applied at a former process may be mixed into the light-emitting layer formed by application at a later process, the ink applied at a later process is not mixed into the light-emitting layer formed by application at a former process. This means that the combination of color mixing of inks depends on the application order of the inks. Based on this phenomenon, the present inventors further have found that color mixing of inks can be inhibited from becoming apparent in the emission color by applying the inks in a predetermined order.

When each ink is supplied in the order of the blue ink supplying step, the green ink supplying step and the red ink supplying step as in the present embodiment, the compositions of the blue ink and the green ink may be mixed into the red light-emitting layer 5R, and the composition of the blue ink may be mixed into the green light-emitting layer 5G. However, the compositions of the green ink and the red ink can be avoided from being mixed into the blue light-emitting layer 5B, and the composition of the red ink can be avoided from being mixed into the green light-emitting layer 5G.

For example, when the red ink is mixed into the blue ink even in a small amount, the composition of the red ink emits light, and thus, whitish light is emitted. In contrast, even when a small amount of the blue ink is mixed into the red ink as in the present embodiment, the composition of the blue ink does not emit light as the emission color is affected, and thus, red light is emitted. This phenomenon is considered to be caused because the light-emitting material having a long emission wavelength tends to more readily emit light when the light-emitting material having a long emission wavelength and the light-emitting material having a short emission wavelength are mixed with each other. That is, when a small amount of the light-emitting material having a long emission wavelength tending to readily emit light is mixed into the light-emitting material having a short emission wavelength, the emission color is apparently affected by the mixing. In contrast, when a small amount of the light-emitting material having a short emission wavelength is mixed into the light-emitting material having a long emission wavelength tending to readily emit light, the emission color is not apparently affected by the mixing. Therefore, it is considered that the above-mentioned phenomenon occurs. Thus, even when a small amount of the constituent material of the light-emitting layer having a short emission wavelength is mixed into the light-emitting layer having a long emission wavelength, color mixing of inks does not become evident in the emission color. In contrast, it is considered that when a small amount of the constituent material of the light-emitting layer having a long emission wavelength is mixed into the light-emitting layer having a short emission wavelength, color mixing of inks becomes evident in the emission color. Accordingly, to obtain the light-emitting layer that emits light in an intended emission color, it is preferable to avoid the constituent material of the light-emitting layer having a long emission wavelength from being mixed into the light-emitting layer having a short emission wavelength. That is, it is preferable to prevent a small amount of the red ink from being mixed into the green ink and the blue ink and to prevent a small amount of the green ink from being mixed into the blue ink.

As indicated in Example, even when the compositions of the blue ink and the green ink are mixed into the red light-emitting layer 5R, the red light-emitting layer 5R emits red light, and even when the composition of the blue ink is mixed into the green light-emitting layer 5G, the green light-emitting layer 5G emits green light. Understandably, the blue light-emitting layer 5B with no other ink being mixed thereinto emits blue light. However, when the inks are applied in different order from that of the present embodiment, color mixing of inks becomes evident in the emission color, and as a result, the organic EL element 3 emits light whiter than an intended color.

The combination of inks to be mixed depends on the application order of the inks as described above. Therefore, the present inventors perform the red ink supplying step at the last among the red ink supplying step, the blue ink supplying step and the green ink supplying step and preferably perform the green ink supplying step after the blue ink supplying step to prevent a small amount of the red ink from being mixed into the green ink and the blue ink and prevent a small amount of the green ink from being mixed into the blue ink.

With reference to FIG. 3, the behavior of inks when the inks are applied and the formation of the light-emitting layer 5 are described. The one electrode 6, the insulating film 8 and the hole injection layer 9 are not shown in FIG. 3 because they are unnecessary for describing the behavior of the inks. FIG. 3 is a view corresponding to a sectional view of the organic EL device 1 illustrated in FIG. 1 taken along a cut surface vertical to the column direction Y. In FIG. 3, the blue ink is supplied into the rightmost concave portion to form the blue light-emitting layer 5B, the green ink is supplied into the center concave portion to form the green light-emitting layer 5G, and the red ink is supplied into the leftmost concave portion to form the red light-emitting layer 5R.

### (Blue ink supplying step)

As illustrated in FIG. 3(1), the blue ink is supplied into a predetermined concave portion 11 (the rightmost concave portion 11 in the figure) by a predetermined coating method. The blue ink is supplied at an interval of two columns of the concave portions. While the blue ink supplied in the predetermined concave portion forms into a thin film as the solvent evaporates, the blue ink wets and spreads along the partition 4. Therefore, the blue ink forms into the thin film while being spread to the side of the partition 4 facing the neighboring concave portion separated by the partition 4 (see FIG. 3(2)). The thin film is formed also on the leftmost partition 4 in FIG. 3(2). This is because the blue ink is supplied at an interval of two columns of the concave portions and is supplied also in the concave portion on the left of the leftmost concave portion in FIG. 3.

### (Green ink supplying step)

As illustrated in FIG. 3(3), the green ink is supplied into the predetermined concave portion 11 (the center concave portion 11 in the figure) by a predetermined coating method. The green ink is supplied at an interval of two columns of the concave portions 11. The thin film of the blue ink is overcoated with one end of the supplied green ink in the row direction X at the concave portion 11. The thin film of the blue ink redissolves in the green ink, and thus, it is estimated that the solid content concentration of the green ink applied onto the film increases to lead to the increase in its viscosity. Although the green ink spreads along the thin film of the blue ink, its viscosity increases as the green ink spreads, which inhibits the spreading of the green ink. Therefore, the green ink does not wet and spread on the thin film of the blue ink, and the green ink can be prevented from being mixed into the concave portion 11 supplied with the blue ink. On the other hand, the other end of the green ink in the row direction X wets and spreads along the partition 4, and therefore, a thin film of the green ink is formed onto the concave portion 11 to be supplied with the red ink described later (see FIG. 3(4)).

### (Red ink supplying step)

As illustrated in FIG. 3(5), the red ink is supplied into the predetermined concave portion 11 (the leftmost concave portion 11 in the figure) by a predetermined coating method. The red ink is supplied at an interval of two columns of the concave portions 11. The red ink forms into a thin film as the solvent evaporates. The thin film of the green ink is overcoated with one end of the supplied red ink in the row direction X at the concave portion 11. The thin film of the green ink redissolves in the red ink, and thus, it is estimated that the solid content concentration of the red ink increases to lead to the increase in its viscosity. Therefore, the red ink does not wet and spread on the thin film of the green ink, and the red ink can be prevented from being mixed into the concave portion 11 supplied with the green ink. The thin film of the blue ink is overcoated with the other end of the red ink in the row direction X at the concave portion 11, and the red ink can be prevented from being mixed into the concave portion 11 supplied with the blue ink as with the one end of the red ink in the row direction X at the concave portion 11 (see FIG. 3(6)).

In the present embodiment, the inks wet and spread on the hole injection layer 9. Even when no hole injection layer 9 is provided, the inks wet and spread on the partition 4, and thus, the inks behave in a manner similar to the behavior as described above.

### (Step of solidifying ink)

The light-emitting layer is obtained by solidifying the ink. The ink is solidified by drying it at room temperature or under heating. The ink is preferably dried in an atmosphere of an inert gas of nitrogen or the like, or in a vacuum atmosphere. When the ink includes a material that is polymerized by heat application or light radiation, the ink is preferably solidified by heat application or light radiation. Solidifying the ink may be conducted every time each ink is supplied, but it is preferably conducted after all types of inks are supplied. This is because the solidifying step can be performed at once. The solidifying step is not particularly performed when the ink is air dried.

As described above, when each of the inks is supplied at the blue ink supplying step, the green ink supplying step and the red ink supplying step in this order, the compositions of the blue ink and the green ink may be mixed into the red light-emitting layer 5R, and the composition of the blue ink may be mixed into the green light-emitting layer 5G. However, the compositions of the green ink and the red ink can be avoided from being mixed into the blue light-emitting layer 5B, and the composition of the red ink can be avoided from being mixed into the green light-emitting layer 5G. Thus, even when the partition having lyophilic properties is used without hydrophobizing the partition and increasing the number of processes, the light-emitting layer 5 in which the blue light-emitting layer 5B emits blue light, the green light-emitting layer 5G emits green light and the red light-emitting layer 5B emits red light can be obtained. The organic EL element 3 emitting light in an intended color can be simply manufactured by a coating method without increasing the number of processes.

By the process described above, one end of each of the green light-emitting layer and the blue light-emitting layer extends along the partitions onto the neighboring red light-emitting layer separated by the partitions.

### <Coating method>

Each ink is supplied in the predetermined concave portion 11 by a predetermined coating method. Examples of the coating method may include a casting method, a micro-gravure coating method, a gravure coating method, a bar coating method, a roll coating method, a wire bar coating method, a slit coating method, a capillary coating method, a spray coating method, a nozzle coating method, a gravure printing method, a screen printing method, a flexo printing method, an offset printing method, a reverse printing method and an ink-jet printing method. The coating method is preferably a nozzle coating method or a plate printing method, more preferably a relief printing method, and further preferably a flexo printing method.

<Ink>

Each ink of the red ink, the green ink and the blue ink is prepared by dissolving materials of each light-emitting layer into a solvent. The proportion of the material of the light-emitting layer to the ink (hereinafter may be referred to as a solid content concentration) is generally 0.1% by weight to 5% by weight, and preferably 0.5% by weight to 3% by weight. The solid content concentration or the concentration of the solvent in the present specification means the concentration in a tank containing inks in a coater.

A solvent favorably dissolving the material of the light-emitting layer is preferable. Examples of the solvent may include: chlorine based solvents such as chloroform, methylene chloride and dichloroethane; ether based solvents such as tetrahydrofuran; aromatic hydrocarbon based solvents such as toluene, xylene and cyclohexylbenzene; ketone based solvents such as acetone and methyl ethyl ketone; and ester based solvents such as ethyl acetate, butyl acetate and ethyl cellosolve acetate. One type of the solvent may be used singly, or plural types of the solvents may also be used in combination.

To form a flat light-emitting layer, the solvent preferably includes a solvent having a boiling point of 200 °C or higher (hereinafter may be referred to as a high-boiling-point solvent), and the proportion of the solvent having a boiling point of 200°C or higher to the ink is preferably 5% by weight or larger. The ink is unlikely evaporated by including such high-boiling-point solvent.

The ink is evaporated during a middle process before the ink is supplied to the predetermined concave portion 11. Therefore, the solid content concentration of the ink when the ink is supplied to the predetermined concave portion 11 is higher than the solid content concentration of the ink in the tank containing the ink. As a result, the viscosity of the ink when the ink is supplied to the predetermined concave portion 11 is also higher than the viscosity of the ink in the tank. When the ink having high viscosity is supplied to the concave portion 11, the ink resists wetting and spreading, and the surface of the light-emitting layer may not be flattened. Particularly, in a plate printing method, the ink adheres to a plate and then is transferred. Therefore, the amount of the solvent evaporated during a middle process increases, and the viscosity of the ink when the ink is supplied to the predetermined concave portion 11 increases. For this reason, in a plate printing method, it is difficult to obtain a flat light-emitting layer. However, it is considered that the use of the solvent that has a high boiling point and is unlikely evaporated as described above can inhibit evaporation of the solvent during a middle process to suppress the increase in viscosity of the ink, and thus, a flat light-emitting layer can be obtained. When the ink containing the high boiling point solvent is used while the partition 4 having lyophilic properties is used, the ink having a low viscosity may wet and spread along the partition 4 to cause color mixing of inks. However, color mixing of inks can be prevented from becoming apparent in the emission color by defining the application order as in the present embodiment. By defining such application order and using the ink containing the high-boiling-point solvent, a light-emitting layer with an even thickness can be obtained while color mixing of inks is prevented from becoming apparent in the emission color. In a flexo printing method using a plate made of an elastic substance such as a resin, the plate absorbs the solvent, and as a result, the increase in the solid content concentration becomes prominent. It is therefore difficult to form a light-emitting layer with an even thickness and prevent occurrence of a color mixing problem when using the partition 4 having lyophilic properties. However, intended light-emitting layers can be obtained by applying the inks in the application order of the present embodiment and using the high boiling point solvent.

For the solvent having a boiling point of 200°C or higher, the above mentioned cyclohexylbenzene may be used. The proportion of the solvent having a boiling point of 200°C or higher to the ink is preferably 5% by weight to 70% by weight, and further preferably 10% by weight to 50% by weight.

### <Material to be light-emitting layer>

The light-emitting layer is generally made of an organic substance that mainly emits fluorescence and/or phosphorescence, or made of the organic substance and a dopant assisting the organic substance. The dopant is added in order to, for example, improve the luminous efficiency and change the emission wavelength. The organic substance may be a low molecular compound or a high molecular compound. From the viewpoint of solubility in solvents, the light-emitting layer preferably includes a high molecular compound having a polystyrene equivalent number average molecular weight of 10³ to 10⁸. Examples of light-emitting materials constituting the light-emitting layer may include the following pigment-based materials, metal complex-based materials, polymer-based materials and dopant materials.

### (Pigment-based materials)

Examples of the pigment-based materials include cyclopentamine derivatives, tetraphenyl butadiene derivative compounds, triphenyl amine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, oxadiazole dimers, pyrazoline dimers, quinacridone derivatives, and coumarin derivatives.

### (Metal complex-based materials)

Examples of the metal complex-based materials include metal complexes having, as a central metal, a rare-earth metal such as Tb, Eu and Dy, Al, Zn, Be, Ir, Pt, or the like and having, as a ligand, a structure of oxadiazole, thiadiazole, phenylpyridine, phenylbenzimidazole, quinoline, or the like. Examples of the metal complex-based materials may include metal complexes that emit light from the triplet excited state such as iridium complexes and platinum complexes; aluminumquinolinol complexes; benzoquinolinole beryllium complexes; benzoxazolyl zinc complexes; benzothiazole zinc complexes; azomethyl zinc complexes; porphyrin zinc complexes; and phenanthroline europium complexes.

### (Polymer-based materials)

Examples of the polymer-based materials may include polyparaphenylene vinylene derivatives, polythiophene derivatives, polyparaphenylene derivatives, polysilane derivatives, polyacetylene derivatives, polyfluorene derivatives, polyvinyl carbazole derivatives, and materials obtained by polymerizing the pigment-based materials or the metal complex-based light-emitting materials described above.

Among the light-emitting materials described above, examples of the material emitting blue light may include distyrylarylene derivatives, oxadiazole derivatives, and polymers thereof, polyvinyl carbazole derivatives, polyparaphenylene derivatives and polyfluorene derivatives. Among them, polymer materials such as polyvinyl carbazole derivatives, polyparaphenylene derivatives and polyfluorene derivatives are preferred.

Examples of the material emitting green light may include quinacridone derivatives, coumarin derivatives, and polymers thereof, polyparaphenylene vinylene derivatives and polyfluorene derivatives. Among them, polymer materials such as polyparaphenylene vinylene derivatives and polyfluorene derivatives are preferred.

Examples of the material emitting red light may include coumarin derivatives, thiophene ring compounds, and polymers thereof, polyparaphenylene vinylene derivatives, polythiophene derivatives and polyfluorene derivatives. Among them, polymer materials such as polyparaphenylene vinylene derivatives, polythiophene derivatives and polyfluorene derivatives are preferred.

### (Dopant materials)

Examples of the dopant materials may include perylene derivatives, coumarin derivatives, rubrene derivatives, quinacridone derivatives, squarylium derivatives, porphyrin derivatives, styryl pigments, tetracene derivatives, pyrazolone derivatives, decacyclene and phenoxazon. The thickness of such a light-emitting layer is generally about 2 nm to 200 nm.

### (Step of forming the other electrode)

In the present embodiment, the cathode 7 is formed as the other electrode. The organic EL elements 3 are electrically insulated from each other with the insulating film 8 in the present embodiment, and therefore, the cathode 7 is formed all over the substrate from above. In other words, the common electrode 7 is formed for each organic EL element 3.

### <Cathode>

A material that has a low work function, facilitates electron injection into the light-emitting layer, and has high electric conductivity is preferred as a material of the cathode. In the organic EL element in which light is extracted from the anode side, a material having high visible light reflectance is preferred as the material of the cathode because the cathode reflects the light output from the light-emitting layer to the anode. For example, alkali metals, alkaline-earth metals, transition metals, and the metals of Group 13 of the Periodic Table may be used for the cathode. Examples of the materials used for the cathode may include: metals such as lithium, sodium, potassium, rubidium, cesium, beryllium, magnesium, calcium, strontium, barium, aluminum, scandium, vanadium, zinc, yttrium, indium, cerium, samarium, europium, terbium and ytterbium; alloys of two or more of the metals; alloys of one or more of the metals and one or more of gold, silver, platinum, copper, manganese, titanium, cobalt, nickel, tungsten and tin; and graphite or graphite intercalation compounds. Examples of the alloys may include magnesium-silver alloys, magnesium-indium alloys, magnesium-aluminum alloys, indium-silver alloys, lithium-aluminum alloys, lithium-magnesium alloys, lithium-indium alloys and calcium-aluminum alloys. For the cathode, a transparent conductive electrode made of a conductive metal oxide, a conductive organic substance, or the like can be used as needed. Specific examples of the conductive metal oxide may include indium oxide, zinc oxide, tin oxide, ITO and IZO. Specific examples of the conductive organic substance may include polyaniline or derivatives thereof, and polythiophene or derivatives thereof. The cathode may be a stacked body in which two or more layers are stacked.

The thickness of the cathode is appropriately designed in consideration of required properties, simplicity of processes, and the like. The thickness of the cathode is, for example, 10 nm to 10 µm, preferably 20 nm to 1µm, and further preferably 50 nm to 500 nm.

The cathode can be formed by a vacuum deposition method, a sputtering method, a lamination method in which a metal thin film is thermocompression bonded, or the like.

The organic EL device 1 of the present embodiment as described above includes the organic EL element having a structure in which the one electrode is the anode, the other electrode is the cathode, and the hole injection layer is provided between the anode and the light-emitting layer. However, the layer structure of the organic EL element mounted on the organic EL device is not limited to the structure.

The organic EL element comprises at least a pair of electrodes and a light-emitting layer interposed between the electrodes. The organic EL element may include another layer different from the light-emitting layer at a position between the anode and the light-emitting layer and/or a position between the light-emitting layer and the cathode. Not only one light-emitting layer but also a plurality of light-emitting layers may be provided between the electrodes.

Examples of the layer provided between the cathode and the light-emitting layer may include an electron injection layer, an electron transport layer, and a hole block layer. When a single layer is provided between the cathode and the light-emitting layer, the layer is called the electron injection layer. When both of the electron injection layer and the electron transport layer are provided between the cathode and the light-emitting layer, a layer in contact with the cathode is called the electron injection layer, and a layer except for the electron injection layer is called the electron transport layer.

The electron injection layer has function to improve electron injection efficiency from the cathode. The electron transport layer has function to improve electron injection from the cathode, the electron injection layer, or the electron transport layer closer to the cathode. The hole block layer has function to block the transport of holes. When the electron injection layer and/or the electron transport layer has function to block the transport of holes, such layer may also serve as the hole block layer.

The function of the hole block layer to block the transport of holes can be confirmed by, for example, preparing an element in which only hole current flows and confirming an effect of blocking holes based on the reduction of the current value.

Examples of the layer provided between the anode and the light-emitting layer may include a hole injection layer, a hole transport layer, and an electron block layer. When a single layer is provided between the anode and the light-emitting layer, the layer is called the hole injection layer. When both of the hole injection layer and the hole transport layer are provided between the anode and the light-emitting layer, a layer in contact with the anode is called the hole injection layer, and a layer except for the hole injection layer is called the hole transport layer.

The hole injection layer has function to improve hole injection efficiency from the anode. The hole transport layer has function to improve hole injection from the anode, the hole injection layer, or the hole transport layer closer to the anode.
The electron block layer has function to block the transport of electrons. When the hole injection layer and/or the hole transport layer has function to block the transport of electrons, such layer may also serve as the electron block layer.

The function of the electron block layer to block the transport of electrons can be confirmed by, for example, preparing an element in which only electron current flows and confirming an effect of blocking electrons based on the reduction of the current value.

Applicable layer structures of the organic EL element of the present embodiment are exemplified below.
a) anode/light-emitting layer/cathode
b) anode/hole injection layer/light-emitting layer/cathode
c) anode/hole injection layer/light-emitting layer/electron injection layer/cathode
d) anode/hole injection layer/light-emitting layer/electron transport layer/cathode
e) anode/hole injection layer/light-emitting layer/electron transport layer/electron injection layer/cathode
f) anode/hole transport layer/light-emitting layer/cathode
g) anode/hole transport layer/light-emitting layer/electron injection layer/cathode
h) anode/hole transport layer/light-emitting layer/electron transport layer/cathode
i) anode/hole transport layer/light-emitting layer/electron transport layer/electron injection layer/cathode
j) anode/hole injection layer/hole transport layer/light-emitting layer/cathode
k) anode/hole injection layer/hole transport layer/light-emitting layer/electron injection layer/cathode
l) anode/hole injection layer/hole transport layer/light-emitting layer/electron transport layer/cathode
m) anode/hole injection layer/hole transport layer/light-emitting layer/electron transport layer/electron injection layer/cathode
n) anode/light-emitting layer/electron injection layer/cathode
o) anode/light-emitting layer/electron transport layer/cathode
p) anode/light-emitting layer/electron transport layer/electron injection layer/cathode
   (wherein a symbol "/" indicates that the layers across the symbol "/" are adjacently stacked. The same shall apply hereinafter.)

The organic EL element of the present embodiment may include two or more light-emitting layers. When a stacked body interposed between an anode and a cathode in any one of the layer structures of a) to p) described above is indicated by a "structural unit A", an example of the structure of the organic EL element having two light-emitting layers may include a layer structure of the following q). The layer structures of the two (structural unit A) may be the same as or different from each other.
q) anode/(structural unit A)/charge generation layer/(structural unit A)/cathode

When "(structural unit A)/charge generation layer" is indicated by a "structural unit B", an example of the structure of the organic EL element having three or more light-emitting layers may include a layer structure of the following p).
r) anode/(structural unit B)x/(structural unit A)/cathode

In this structure, a symbol "x" is an integer of two or more, and (structural unit B)x indicates a stacked body in which the structural unit B is stacked x times. The layer structures of a plurality of "structural unit B" may be the same as or different from each other.

The charge generation layer is a layer that generates holes and electrons when electric field is applied thereto. An example of the charge generation layer may include a thin film of vanadium oxide, indium tin oxide (Abbrev.:ITO), molybdenum oxide, or the like.

The organic EL element may be covered by a sealing member such as a sealing film or a sealing plate for sealing. When the organic EL element is provided on the substrate, generally, the anode is arranged near the substrate as in the present embodiment, but the cathode may be arranged near the substrate. In other words, in the embodiments of a) to p), each layer may be stacked on the substrate in the order starting from the left, but each layer may also be stacked on the substrate in the order starting from the right. The order or the number of the layers to be stacked and the thickness of each layer can be appropriately designed in consideration of element characteristics, simplicity of processes, and the like.

Next, the material and the forming method for each layer constituting the organic EL element are described more specifically. The anode, the hole injection layer, the light-emitting layer and the cathode are described above, and thus, redundant description is omitted.

### <Hole transport layer>

Examples of hole transport materials constituting the hole transport layer may include polyvinyl carbazole or derivatives thereof, polysilane or derivatives thereof, polysiloxane derivatives having an aromatic amine at the side chain or the main chain, pyrazoline derivatives, arylamine derivatives, stilbene derivatives, triphenyldiamine derivatives, polyaniline or derivatives thereof, polythiophene or derivatives thereof, polyarylamine or derivatives thereof, polypyrrole or derivatives thereof, poly(p-phenylenevinylene) or derivatives thereof, and poly(2,5-thienylene vinylene) or derivatives thereof.

Among them, the hole transport material is preferably a polymer hole transport material such as polyvinyl carbazole or derivatives thereof, polysilane or derivatives thereof, polysiloxane derivatives having an aromatic amine compound group at the side chain or the main chain, polyaniline or derivatives thereof, polythiophene or derivatives thereof, polyarylamine or derivatives thereof, poly(p-phenylenevinylene) or derivatives thereof, and poly(2,5-thienylene vinylene) or derivatives thereof, and further preferably polyvinyl carbazole or derivatives thereof, polysilane or derivatives thereof, or polysiloxane derivatives having an aromatic amine at the side chain or the main chain. When the hole transport material is a low molecular material, it is preferable that the material is used by being dispersed in a polymer binder.

A method for forming a film of the hole transport layer is not particularly limited. An example of the method for forming the film using a low molecular hole transport material may include a film formation from a mixed solution of a polymer binder and the hole transport material, and an example of the method of forming the film using a polymer hole transport material may include a film formation from a solution containing the hole transport material.

A solvent used for the film formation from the solution is not particularly limited so long as the solvent dissolves the hole transport material. Examples of the solvent may include: a chlorine based solvent such as chloroform, methylene chloride and dichloroethane; an ether based solvent such as tetrahydrofuran; an aromatic hydrocarbon based solvent such as toluene and xylene; a ketone based solvent such as acetone and methyl ethyl ketone; and an ester based solvent such as ethyl acetate, butyl acetate and ethyl cellosolve acetate.

An example of the method for the film formation from the solution may include a coating method similar to the method for the film formation of the hole injection layer described above.

For the polymer binder to be mixed, a binder that does not extremely inhibit charge transportation is preferable, and a binder that has weak absorption of visible light is suitably used. Examples of the polymer binder may include polycarbonate, polyacrylate, polymethyl acrylate, polymethyl methacrylate, polystyrene, polyvinyl chloride and polysiloxane.

The thickness of the hole transport layer is appropriately designed in consideration of required properties, simplicity of processes, and the like. The thickness of the hole transport layer is, for example, 1 nm to 1 µm, preferably 2 nm to 500 nm, and further preferably 5 nm to 200 nm.

### <Electron transport layer>

Examples of the electron transport materials constituting the electron transport layer may include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, metal complexes of 8-hydroxyquinoline or of derivatives of 8-hydroxyquinoline, polyquinoline or derivatives thereof, polyquinoxaline or derivatives thereof, and polyfluorene or derivatives thereof.

Among them, for the electron transport materials, oxadiazole derivatives, benzoquinone or derivatives thereof, anthraquinone or derivatives thereof, metal complexes of 8-hydroxyquinoline or of derivatives of 8-hydroxyquinoline, polyquinoline or derivatives thereof, polyquinoxaline or derivatives thereof, and polyfluorene or derivatives thereof are preferred, and 2-(4-biphenylyl)-5-(4-t-butylphenyl)-1,3,4-oxadiazole, benzoquinone, anthraquinone, tris(8-quinolinol)aluminum, and polyquinoline are further preferred.

A method for forming a film of the electron transport layer is not particularly limited. Examples of the method for forming the film using a low molecular electron transport material may include a vacuum deposition method using the powder, and a film formation from the solution or from the melted state, and an example of the method for forming the film using a polymer electron transport material may include a film formation from the solution or from the melted state. When the film is formed from the solution or from the melted state, a polymer binder may be used in combination. An example of a method for forming the film of the electron transport layer from the solution may include a film forming method similar to the method for forming the film of the hole injection layer from the solution as described above.

The thickness of the electron transport layer is appropriately designed in consideration of required properties, simplicity of processes, and the like. The thickness of the electron transport layer is, for example, 1 nm to 1 µm, preferably 2 nm to 500 nm, and further preferably 5 nm to 200 nm.

### <Electron injection layer>

For materials constituting the electron injection layer, optimal materials are appropriately selected depending on the type of the light-emitting layer. Examples of the material may include: alkali metals; alkaline-earth metals; alloys containing one or more of alkali metals and alkaline-earth metals; oxides, halides and carbonates of alkali metals or alkaline-earth metals; and a mixture of these substances. Examples of the alkali metals, and the oxides, halides and carbonates of alkali metals may include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of the alkaline-earth metals, and the oxides, halides and carbonates of alkaline-earth metals may include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may be a stacked body in which two or more layers are stacked, and an example thereof may include LiF/Ca. The electron injection layer is formed by a vapor deposition method, a sputtering method, a printing method, or the like.
The thickness of the electron injection layer is preferably about 1 nm to 1 µm.

The organic EL device described above can be suitably used in a display device. Examples of the display device including the organic EL element may include a segment display device and a dot-matrix display device.

### Examples

Inks of the blue ink, the green ink and the red ink (B, G, and R) were applied in this order, thus manufacturing three types of organic EL elements.

### (Preparation of substrate and formation of anode)

On a transparent glass plate of 200 mm (long)×200 mm (wide)×0.7 mm (thick), a substrate with a TFT array and a plurality of anodes (one of electrodes) formed thereon was prepared. The plurality of anodes were arrayed in a matrix form. The anode had a plate shape and had the size of a width in the row direction X of 60 µm, a width in the column direction Y of 180 µm, and a thickness of 150 nm. An ITO thin film was used for the anode.

### (Formation of insulating film)

Subsequently, a positive photoresist (trade name "SL-1904", manufactured by Toray Industries, Inc.) was applied to the whole surface of the substrate and was subjected to photolithography, thus forming a grid-like insulating film with openings formed on the anodes. The thickness of the insulating film was 1.8 µm, and the opening had a width in the row direction X of 55 µm and a width in the column direction Y of 175 µm.

### (Formation of partition)

Subsequently, a positive photoresist (trade name "SL-1904", manufactured by Toray Industries, Inc.) was applied to the whole surface of the substrate and was subjected to photolithography, thus forming partitions in stripe shapes. The formed partition had a height of 2 µm, a width in the row direction X of 33 µm, a space between the neighboring partitions of 41.5 µm, and a pitch (repetition) in the row direction X of 74.5 (33+41.5) µm. When the partitions are formed by typical photolithography using the photoresist described above, the formed partitions generally have lyophilic properties unless hydrophobizing treatment is further performed.

### (Formation of hole injection layer)

Subsequently, a suspension of poly(3,4-ethylenedioxythiophene)/polystyrene sulfonate (trade name "Baytron P AI4083", manufactured by Bayer AG) was filtered using a membrane filter of 0.2 µm. The filtrate was applied on the substrate by spin coating. Subsequently, the substrate was subjected to heat treatment at 200°C for 20 minutes, thus forming a hole injection layer having a thickness of 80 nm.

### (Formation of light-emitting layer)

A flexographic printing plate (quality of material: polyester resin) comprising a plurality of convex portions in stripe shapes corresponding to the partitions described above was prepared. The convex portions extended along the circumferential direction of the plate cylinder and were arranged to be spaced from each other at regular intervals in the central axis direction. The convex portion had a height of 100 µm, a width of 35 µm, and a repetition interval (pitch) of 223.5 (74.5x3) µm.

Three types of inks (solid content concentration of each ink: 2% by weight) in which each of polymer light-emitting materials in three colors of red, green and blue (trade name "RP158 (red)", "GP1300 (green)", and "BP361 (blue)", manufactured by Sumation Co., Ltd.) as organic light-emitting materials was dissolved in a mixed solvent of anisole/cyclohexylbenzene=1/1 (weight ratio) were prepared.

The prepared inks were applied by a flexo printing method in the order of the blue ink, the green ink and the red ink (B, G and R). The blue ink was printed at concave portions in which blue light-emitting layers are to be formed using the flexographic printing plate including the convex portions and was then dried, thus forming the blue light-emitting layers. Subsequently, the green ink was printed in a manner similar to the blue ink and was then dried, thus forming green light-emitting layers. The red ink was printed in a manner similar to the green ink and was then dried, thus forming red light-emitting layers. The thicknesses of the light-emitting layers 5R, 5G and 5B in each color were each 60 nm and were substantially the same.

"Angstromer SDR-0023 (trade name), plate drum diameter: 80 mm" manufactured by Nissha Printing Co., Ltd was used for the printer. Printing was performed at a printing speed of 50 mm/sec in a state where the plate is pressed for 50 µm (print pressing amount=50 µm) from the position where a print pressing amount when the plate came in contact with the substrate was assumed to be 0 µm.

The shape of each light-emitting layer was observed with an optical microscope (trade name "Optiphoto 88", objective lens magnification: magnification of 50X, manufactured by Nicon System Inc). As a result, the film shape as illustrated in FIG. 3(5) was observed in which the blue ink, the green ink and the red ink all extended onto the partitions.

### (Formation of cathode)

Subsequently, calcium was vapor deposited onto the light-emitting layer in a thickness of 100 Å as the other electrode (cathode), and aluminum was vapor deposited thereon in a thickness of 2000 Å as an oxidation protecting layer. In such a manner, bottom emission type organic EL elements were manufactured.

When the obtained organic EL elements were made to emit light, red light, green light and blue light were obtained from the organic EL elements whose light-emitting layers were formed using the red ink, the green ink and the blue ink, respectively. No color mixing was observed.

### [Comparative Example]

Inks of the blue ink, the green ink and the red ink (R, G and B) were applied in this order, thus manufacturing three types of organic EL elements.

The organic EL elements were manufactured in a manner similar to Example except that the inks were applied in the order of the red ink, the green ink and the blue ink.

When the obtained organic EL elements were made to emit light, the organic EL elements whose light-emitting layers were formed using the blue ink emitted white light. This is assumed that the composition of the red ink was mixed into the light-emitting layers formed using the blue ink and emitted red light, and as a result of obtaining both red light and blue light, white light emission was observed.

### Industrial Applicability

According to the present invention, an intended organic EL elements can be manufactured with fewer processes, using a partition having lyophilic properties, so that the color mixing problem dose not become evident, and then an organic EL device can be simply manufactured.

## Claims

1. A method for manufacturing an organic electroluminescent device that comprises a substrate, a plurality of organic electroluminescent elements provided on the substrate, and a partition sectioning the plurality of organic electroluminescent elements, in which the plurality of organic electroluminescent elements comprise a light-emitting layer formed by a coating method and a pair of electrodes arranged with the light-emitting layer interposed therebetween, and include a red light-emitting layer emitting red light, a green light-emitting layer emitting green light or a blue light-emitting layer emitting blue light as the light-emitting layer, the method comprising:
a step of preparing the substrate provided with the partition having lyophilic properties and with one electrode of the pair of electrodes;
a red ink supplying step of supplying an ink for forming the red light-emitting layer onto the one electrode for forming the red light-emitting layer by the coating method;
a green ink supplying step of supplying an ink for forming the green light-emitting layer onto the one electrode for forming the green light-emitting layer by the coating method;
a blue ink supplying step of supplying an ink for forming the blue light-emitting layer onto the one electrode for forming the blue light-emitting layer by the coating method;
a step of solidifying the supplied inks; and
a step of forming the other electrode of the pair of electrodes, wherein
the red ink supplying step is performed at the last among the red ink supplying step, the blue ink supplying step and the green ink supplying step.

2. The method for manufacturing an organic electroluminescent device according to claim 1, wherein the green ink supplying step is performed after the blue ink supplying step.

3. The method for manufacturing an organic electroluminescent device according to claim 1 or 2, wherein the coating method is a nozzle coating method or a plate printing method.

4. The method for manufacturing an organic electroluminescent device according to any one of claims 1 to 3, wherein the coating method is a relief printing method.

5. The method for manufacturing an organic electroluminescent device according to any one of claims 1 to 4, wherein
the inks contain a solvent having a boiling point of 200°C or higher, and
a proportion of the solvent having a boiling point of 200°C or higher to the ink is 5% by weight or larger.

6. An organic electroluminescent device comprising a substrate, a plurality of organic electroluminescent elements provided on the substrate, and a partition sectioning the plurality of organic electroluminescent elements, wherein
the plurality of organic electroluminescent elements comprise a light-emitting layer formed by a coating method and a pair of electrodes arranged with the light-emitting layer interposed therebetween, and include a red light-emitting layer emitting red light, a green light-emitting layer emitting green light or a blue light-emitting layer emitting blue light as the light-emitting layer,
the partition has lyophilic properties, and
one end of the green light-emitting layer and/or the blue light-emitting layer extends along the partition onto the neighboring red light-emitting layer separated by the partition.

7. A display device comprising the organic electroluminescent device of claim 6.
